# EUROPEAN PATENT APPLICATION

(11) **EP 1 548 843 A1**
(43) Date of publication of application: **29.06.2005**
(21) Application number: 03794228.1
(22) Date of filing: 04.09.2003
(51) Int. Cl.: H01L 29/82, H01L 29/78

(54) **FIELD-EFFECT TRANSISTOR**

(30) Priority: 05.09.2002 JP 2002260536
(71) Applicant: Japan Science and Technology Agency, Kawaguchi-shi, Saitama 332-0012 (JP)
(72) Inventor: TANAKA, Hidekazu, Suita-shi, Osaka 565-0821 (JP); KAWAI, Tomoji, Mino-shi, Osaka 562-0031 (JP); KANKI, Teruo, Toyonaka-shi, Osaka 560-0033 (JP); PARK, Young-Geun, Mino-shi, Osaka 562-0031 (JP)
(74) Representative: Bentz, Jean-Paul
(86) International application number: PCT/JP2003/011300
(87) International publication number: WO 2004/023563

(57) **Abstract**

The field-effect transistor includes: a ferromagnetic layer, having a film thickness of 50 nm or less, which is made of a Ba-Mn oxide showing ferromagnetism at 0°C or higher; a dielectric layer made of a dielectric material or a ferroelectric material, and the ferromagnetic layer and the dielectric layer are bonded to each other. Thus, it is possible to control the magnetism, the electricity transport property, and/or the magnetic resistivity effect at 0°C or higher.

## Description

### TECHNICAL FIELD

The present invention relates to a field-effect transistor, particularly to a field-effect transistor applicable to a magnetic storage device in which information can be written with an electric field, a new-feature semiconductor/magnetic integrated circuit, an electric field control magnetic actuator, and the like.

### BACKGROUND ART

Recently, not only a semiconductor device for controlling flow of electrons but also spintronics for controlling a spin (magnetic source) by a semiconductor technique have been being developed. Further, the development of the spintronics allows ferromagnetic switching whereby carrier density change in a magnetic semiconductor is utilized by applying a voltage, and is expected to realize: a novel magnetic storage element in which information can be written with an electric field; a new-feature semiconductor/magnetic integrated circuit; and the like.

As a field-effect element for controlling the ferromagnetism with an electric field, for example, (i) a field-effect device using a dilute magnetic semiconductor is reported (see Non-patent document 1). According to the report, (In, Mn)As is used as a dilute magnetic material.

Further, as other field-effect element, (ii) a field-effect device using Mn oxide/ferromagnetic oxide is reported (see Non-patent documents 2 to 4 for example).
[Non-patent document 1]
   H. Ohno et al., Nature 408,944-946 (2000)
[Non-patent document 2]
   S. Mathews et al., Science 276 (1997) 238
[Non-patent document 3]
   T. Wu et al., Phys. Rev. Lett. 86 (2001) 5998
[Non-patent document 4]
   S: B Ogale et al., Phys. Rev. Lett. 77 (1996) 1159

However, each of the foregoing conventional field-effect devices raises such problems that: its magnetic transition temperature is low; it is necessary to apply a high electric field; or there is no change in the magnetic transition temperature.

Specifically, in the (i) electric-field element using a dilute magnetic semiconductor, its magnetic transition temperature is extremely low (22.5 K = -250°C). Further, in order to change the magnetic transition temperature, it is necessary to apply a high electric field. Specifically, when a high electric field of 125V is applied, the change (ΔTc) in the magnetic transition temperature is 1 K (ΔTc = 1K). Further, the field-effect device arranged in the foregoing manner shows no memory effect.

Further, in case of using the (ii) Mn oxide/ferromagnetic oxide, most of the field effect devices arranged in this manner show no change in the magnetic transition temperature. Further, also in case of a compound showing a change in its magnetic transition temperature, the magnetic transition temperature is low, and the change in the magnetic transition temperature is small. Specifically, Venkatesan's group (U.S.A) (see Non-patent documents 2 to 4) uses (La, A) MnO₃ (A = Sr, Ca, Nd) as a ferromagnetic layer. As to the ferromagnetic layer arranged in this manner, it is known that its magnetic transition temperature is suddenly reduced by making it thinner which is required in manufacturing the device. Thus, according to the field-effect element arranged in the foregoing manner, it is impossible to control the transition temperature near room temperature for example. As to an example where a field-effect element of (La, Ca) MnO₃ (50nm)/SrTiO₃ is used, a change in its magnetic transition temperature is reported. However, the change in the magnetic transition temperature is ΔTc = 150K + 3 K when a voltage of 5V is applied.

Thus, a field-effect transistor which is operable at 0°C or higher and is operable with a voltage lower than that of conventional arts is desired.

### DISCLOSURE OF INVENTION

The inventors of the present invention diligently studied the foregoing problems. As a result of the study, they combined a Ba-Mn oxide, having an optimal film thickness and an optimal content of Ba atoms, whose interface is flat at an atomic level, with a dielectric material or a ferroelectric material having an optimal residual polarization value and insulating property, in order to obtain a sufficient field effect, thereby completing the present invention.

That is, in order to solve the foregoing problems, a field-effect transistor according to the present invention includes: a ferromagnetic layer, having a film thickness of 50 nm or less, which is made of a Ba-Mn oxide showing ferromagnetism at 0°C or higher; a dielectric layer made of a dielectric material or a ferroelectric material, and the ferromagnetic layer and the dielectric layer are bonded to each other.

According to this arrangement, the field-effect transistor according to the present invention uses a Ba-Mn oxide showing ferromagnetism at 0°C or higher, e.g., a Ba-Mn oxide having a specific composition, as a ferromagnetic layer. Further, the ferromagnetic layer is bonded to the dielectric layer or the ferroelectric layer, so that it is possible to obtain a field-effect transistor having a magnetic transition temperature of 0°C or higher. On this account, it is possible to operate the transistor of the present invention at a temperature much higher than that of conventional arts, that is, at 0°C or higher. Specifically, it is possible to control magnetisim, an electricity transport property, and/or a magnetic resistivity effect, at 0°C or higher.

Further, unlike the dilute magnetic semiconductor for example, the Ba-Mn oxide is a "strong correlational electronic system" in which correlation between electrons is extremely strong. Thus, even a slight change in the carrier density changes a property thereof, so that it is possible to control the transistor of the present invention with a lower voltage than that of the dilute magnetic semiconductor.

As described above, it is possible to operate the field-effect transistor of the present invention with a lower voltage at a higher temperature (0°C or higher) than those of conventional arts.

It is preferable that the field-effect transistor of the present invention has a bottom-gate structure.

The bottom-gate structure is such a structure that: a (La, Ba) MnO₃ layer serving as a channel layer (ferromagnetic layer) is not in contact with a substrate, and its one side is exposed. More specifically, the bottom-gate structure is such a structure that the (La, Ba) MnO₃ layer is exposed.

According to this arrangement, the field-effect transistor of the present invention has the bottom-gate structure, so that the (La, Ba) MnO₃ layer is not in contact with the substrate. Thus, the field-effect transistor of the present invention can be free from any correlation between the substrate and the (La, Ba) MnO₃ layer. Thus, the (La, Ba) MnO₃ layer shows ferromagnetism at 0°C or higher, and it is possible to more widely change the magnetic transition temperature.

For a fuller understanding of the nature and advantages of the invention, reference should be made to the ensuing detailed description taken in conjunction with the accompanying drawings.

### BRIEF DESCRIPTION OF DRAWINGS

Fig. 1 is a cross sectional view schematically showing an arrangement of a field-effect transistor according to an embodiment of the present invention.
Fig. 2 is an oblique perspective view schematically showing a field-effect transistor according to another embodiment of the present invention.
Fig. 3 is a graph showing a condition under which a source-drain resistivity changes when gate-bias sweep is carried out with respect to a top-gate-type field-effect transistor.
Fig. 4 is a graph showing a condition under which a temperature change of the top-gate-type field-effect transistor causes the source-drain resistivity to change.
Fig. 5 is a graph showing a condition under which a temperature change of a bottom-gate-type field-effect transistor causes a source-drain resistivity to change.

### BEST MODE FOR CARRYING OUT THE INVENTION

### [Embodiment 1]

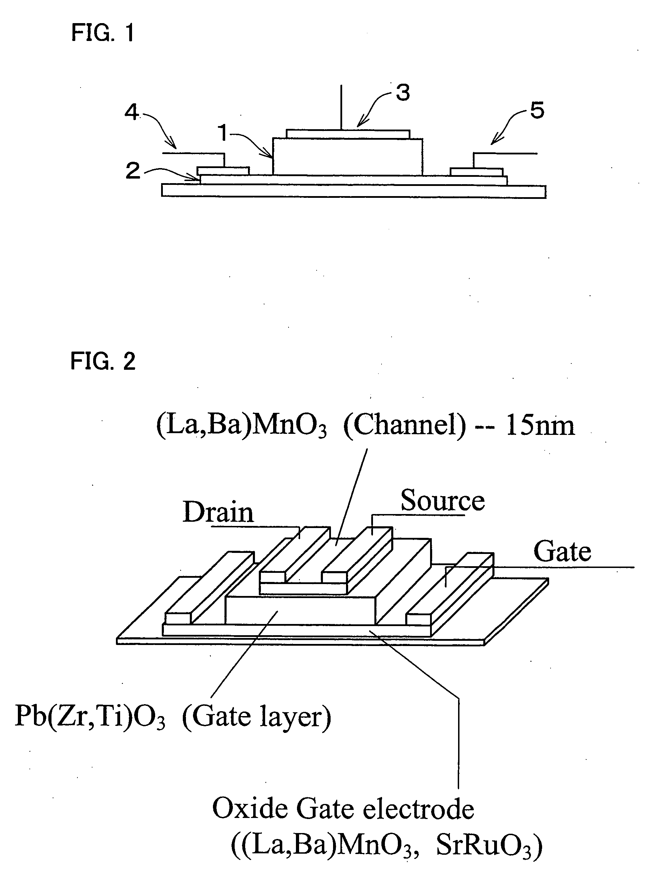

One embodiment of the present invention is described below with reference to Fig. 1.

As shown in Fig. 1, the field-effect transistor according to the present embodiment includes a ferromagnetic layer 2, a dielectric layer 1, a source electrode 4, a gate electrode 3, and a drain electrode 5. Further, the ferromagnetic layer 2 is provided on a substrate.

Specifically, the ferromagnetic layer 2 is provided on the substrate, and the dielectric layer 1 is stacked above the substrate so as to be positioned in a surface having the ferromagnetic layer 2. That is, the substrate, the ferromagnetic layer 2, and the dielectric layer 1 are stacked in this order, and the ferromagnetic layer 2 and the dielectric layer 1 are bonded to each other (hetero junction). Further, the gate electrode 3 is provided on the dielectric layer 1, and the source electrode 4 and the drain electrode 5 are provided on the ferromagnetic layer 2 with the dielectric layer 1 therebetween. At this time, an area in which the dielectric layer 1 and the ferromagnetic layer 2 are bonded to each other corresponds to an operating range of a field-effect transistor.

A material for the ferromagnetic layer 2 is not particularly limited as long as the ferromagnetic layer 2 can be formed evenly and flatly. As a specific example of the material for the ferromagnetic layer 2, it is possible to favorably use (Sr_{1-q} Ba_{q}) TiO₃ (0≤q≤1.0) or a single-crystal material such as MgO and the like. Of the foregoing materials, SrTiO₃ (q=0) is generally known as a standard substrate whose cost is low and electric property is easily controlled; so that it is preferable to use SrTiO₃. Particularly, when the ferromagnetic layer 2 having a film thickness of 100 nm (1000 Å) or less is formed on the single-crystal SrTiO₃ (001) substrate, the Curie temperature is likely to be higher than the Curie temperature of a bulk state, so that this arrangement is preferable. Further, when the foregoing single-crystal material is used, it is possible to easily form the ferromagnetic layer 2 in a thin film shape in case of providing the ferromagnetic layer 2 on the substrate in accordance with laser ablation.

The ferromagnetic layer 2 is made of Ba-Mn oxide which is a ferromagnetic material. The Ba-Mn oxide shows (La, Ba) MnO₃ having a perovskite structure.

The Ba-Mn oxide according to the present embodiment has a film thickness of 50 nm or less, and shows ferromagnetism at 0°C or higher.

An example of the Ba-Mn oxide according to the present embodiment is a composition represented by (La₁₋ₓBaₓ) MnO₃ (note that, x satisfies 0.05<x<0.3). A lower limit of x is preferably more than 0.05, more preferably more than 0.1, particularly preferably 0.15 or more. When x is 0.05 or less, the carrier density is insufficient, so that it is impossible to obtain preferable electric conduction. As a result, it is impossible to obtain the ferromagnetic material. Further, when x is 0.1 or more, more preferably 0.15 or more, the ferromagnetism is shown at 0°C or higher, and it is possible to more widely change the magnetic transition temperature.

While, an upper limit of x is preferably smaller than 0.3, more preferably 0.2 or less. In case where x is 0.3 or more, when the film thickness is 50 nm or less, the ferromagnetism is not shown at 0°C or higher. Thus, when the Ba-Mn oxide is used in the field-effect transistor, it is impossible to operate the field-effect transistor at 0°C or higher, so that this arrangement is not preferable. Note that, the composition of the Ba-Mn oxide may include Mn defect and oxygen defect, but the Mn defect and/or the oxygen defect causes a temperature at which the ferromagnetism is shown to drop, so that it is preferable that these defects are not included in terms of a ferromagnetic material showing the ferromagnetism at 0°C or higher.

The ferromagnetic layer 2 made of Ba-Mn oxide has such a characteristic that: as the ferromagnetic layer is thinner, the ferromagnetic transition temperature is higher. Thus, it is more preferable that the ferromagnetic layer 2 of the field-effect transistor according to the present embodiment is thinner. Specifically, the thickness of the ferromagnetic layer 2 made of Ba-Mn oxide is preferably 50 nm or less, more preferably 10 nm or less, particularly preferably 5 nm or less. The thickness of the ferromagnetic layer 2 made of the Ba-Mn oxide is set to 50 nm or less, so that it is possible to express the ferromagnetism at 0°C or higher. While, a lower limit of the thickness of the ferromagnetic layer 2 is preferably 0.8 nm or more. When the thickness is 0.8 nm or less, the ferromagnetism is theoretically lost.

Further, it is preferable that a temperature at which the ferromagnetism is shown is high. That is, the temperature at which the ferromagnetism is shown is preferably 0°C or higher, more preferably 25°C or higher, further more preferably 40°C or higher. When the temperature at which the ferromagnetism is shown is high, it is possible to raise the magnetic transition temperature of the transistor. That is, in case where the temperature at which the ferromagnetism is shown is a room temperature (25°C) for example, when the ferromagnetic layer 2 is used to manufacture the field-effect transistor, it is possible to operate the field-effect transistor at a room temperature. Thus, in the field-effect transistor according to the present embodiment, the Ba-Mn oxide showing ferromagnetism at 0°C or higher is used as the ferromagnetic layer 2, so that the field-effect transistor can operate at 0°C or higher.

The dielectric layer 1 is made of a ferroelectric material or a dielectric material. The ferroelectric material or the dielectric material constituting the dielectric layer 1 is not particularly limited, and various material can be used as the ferroelectric material or the dielectric material.

Specific examples of the dielectric material include SrTiO₃, Al₂O₃, MgO, and the like. Of the foregoing dielectric materials, it is more preferable to use SrTiO₃ since its dielectric constant is appropriate and SrTiO₃ is easily obtainable.

Further, specific examples of the ferroelectric material include (Ba_{1-y}Sr_{y}) TiO₃ (note that, y satisfies 0<y<1), PbTiO₃, Pb (Zr_{1-z}Ti_{z}) TiO₃ (note that, z satisfies 0<z<1), BaTiO₃, and the like. Of the foregoing ferroelectric materials, it is more preferable to use Pb (Zr, Ti) TiO₃ in terms of ferroelectric polarization.

In the field-effect transistor according to the present embodiment, when the thickness of the ferromagnetic layer 2 is 50 nm or less, an upper limit of the thickness of the dielectric layer 1 is more preferably 400 nm or less, further more preferably 100 nm or less.

As described above, the field-effect transistor according to the present embodiment includes: a ferromagnetic layer 2, having a film thickness of 50 nm or less, which is made of a Ba-Mn oxide showing ferromagnetism at 0°C or higher; a dielectric layer 1 made of a dielectric material or a ferroelectric material, and the ferromagnetic layer 2 and the dielectric layer 1 are bonded to each other. Thus, it is possible to operate the transistor of the present invention at a much higher temperature than that of conventional arts, that is, at 0°C or higher. Specifically, it is possible to control the magnetism, the electricity transport property, and/or the magnetic resistivity effect at 0°C or higher.

Further, unlike the dilute magnetic semiconductor for example, the Ba-Mn oxide is a "strong correlational electronic system" in which correlation between electrons is extremely strong. Thus, even a slight change in the carrier density changes a property thereof, so that it is possible to control the transistor of the present invention with a lower voltage than that of the dilute magnetic semiconductor.

Thus, it is possible to operate the field-effect transistor of the present invention with a lower voltage at a higher temperature (0°C or higher) than those of conventional arts.

Further, when a Ba-MnO₃ represented by (La₁₋ₓBaₓ) MnO₃ (note that, x satisfies 0.05<x<0.3) is used as the ferromagnetic layer 2 and a ferromagnetic material (for example, SrTiO₃) is used as the dielectric layer 1, it is possible to obtain the field-effect transistor which functions as a switching element.

While, in the present embodiment, when a Ba-MnO₃ represented by (La₁₋ₓBaₓ) MnO₃ (note that, x satisfies 0.05<x<0.3) is used as the ferromagnetic layer 2 and a ferromagnetic material (for example, Pb (Zr, Ti) TiO₃) is used as the dielectric layer 1, its modulation is maintained even in case where no voltage is applied, so that the memory effect is shown. Further, when an electric field is applied to the field-effect transistor arranged in the foregoing manner, a layer whose carrier (hole) density is higher or lower than the case where no voltage is applied is formed in the vicinity of a junction of the dielectric layer 1 and the ferromagnetic layer 2. The portion having a high carrier density is referred to as an accumulate layer. The field-effect transistor arranged in the foregoing manner utilizes the accumulate layer, and can be switched from paramagnetism (a state free from any magnetism) to ferromagnetism (a state showing higher magnetism), so that this arrangement is more advantageous in direct magnetism detection than a p-n diode for example.

In the method of the present invention for manufacturing the field-effect transistor, it is possible to form the ferromagnetic layer 2, specifically, in accordance with laser ablation for example. Further, not only the foregoing method but also MBE (Molecular Beam Epitaxy), laser MBE, sputtering, CVD, and the like can be adopted for example. Further, also in case of manufacturing the dielectric layer 1 or the ferroelectric layer 1, the foregoing methods can be adopted. For example, in case where laser ablation is adopted, it is preferable to set the following formation conditions: a substrate temperature ranges from 650 to 7350°C, and the film formation is carried out in an O₂ gas pressure atmosphere ranging from 1.10 × 10⁻¹ to 5.0 × 10⁻¹ Pa. Further, in case of the ferromagnetic layer 2, in order to form the film whose thickness is 50 nm or less, it is more preferable to carry out the film formation at a speed of approximately 10 nm (100 Å)/20 min.

Particularly, in case of providing the ferromagnetic layer 2 made of the (La, Ba) MnO₃ on the substrate, when the film is made thinner at a higher oxygen pressure, it is easier to show the ferromagnetism, and when the film is made thinner at a lower oxygen pressure, it is harder to show the ferromagnetism. This is because: more oxygen in the ferromagnetic layer 2 causes the carrier (positive hole) density to be higher, so that the higher carrier density causes the Curie temperature to be higher.

### [Embodiment 2]

Another embodiment of the present invention is described below with reference to Fig. 2. Note that, in order to facilitate the description, the same reference numbers are given to members having the same functions as those of members described in Embodiment 1, and explanations thereof are omitted.

A field-effect transistor according to the present embodiment is a field-effect transistor having a bottom-gate structure (bottom-gate-type field-effect transistor). The bottom-gate-type field-effect transistor is arranged so that a (La, Ba) MnO₃ serving as a channel layer is not in contact with the substrate and its one side is exposed. That is, in the field-effect transistor according to the present embodiment, the (La, Ba) MnO₃ serving as a channel layer can receive light. Thus, the field-effect transistor according to the present embodiment controls its magnetism with an electric field, so that it is possible to use the field-effect transistor as an optical modulator for controlling a polarization plane of incident light with an electric field. Further, in the field-effect transistor, one side of the (La, Ba) MnO₃ serving as a channel layer is exposed, so that it is possible to advantageously allow the light to come in and out.

Further, as shown in Fig. 2, the field-effect transistor according to the present embodiment is arranged so that an oxide gate electrode made of (La, Ba) MnO₃ or SrRuO₃ is formed between the substrate and the Pb (Zr, Ti) TiO₃ serving as a gate layer. That is, the bottom-gate-type field-effect transistor is arranged so that: the oxide gate electrode, the gate layer (dielectric layer), and the channel layer (ferromagnetic layer) are stacked in this order (the substrate and the oxide gate electrode are in contact with each other). Further, in the field-effect transistor, a drain electrode and a source electrode are provided on a surface of the (La, Ba) MnO₃ serving as a channel layer, and a gate electrode is provided on the oxide gate electrode.

The field-effect transistor according to the present embodiment is a bottom-gate-type field-effect transistor. That is, the (La, Ba) MnO₃ is not in contact with the substrate and is in contact merely with the gate layer unlike the top-gate-type field-effect transistor of Embodiment 1, i.e., the arrangement in which the (La, Ba) MnO₃ is in contact with both the substrate and the gate layer (Pb (Zr, Ti) TiO₃). Generally, a substrate interface has a dead layer which is hard to control. The field-effect transistor according to the present embodiment is not in contact with the substrate, so that it is possible to more greatly change the magnetic transition temperature.

Note that, a method for manufacturing the bottom-gate-type field-effect transistor is the same as the method for manufacturing the top-gate-type field-effect transistor of Embodiment 1 (the gate electrode is positioned in an upper part), so that detail description is omitted.

Further, in case where the oxide gate electrode is made of (La, Ba) MnO₃, it is more preferable that a composition ratio of La and Ba is the same as the composition ratio in the channel layer.

The present invention is not limited to the foregoing embodiments, and can be varied within the scope of claims. Also an embodiment obtained by combining technical means disclosed in different embodiments with each other is included in the technical scope of the present invention.

As described above, the field-effect transistor according to the present invention includes: a ferromagnetic layer, having a film thickness of 50 nm or less, which is made of a Ba-Mn oxide showing ferromagnetism at 0°C or higher; a dielectric layer made of a dielectric material or a ferroelectric material, said ferromagnetic layer and said dielectric layer being bonded to each other.

According to this arrangement, the field-effect transistor according to the present invention uses a Ba-Mn oxide showing ferromagnetism at 0°C or higher, e.g., a Ba-Mn oxide having a specific composition, as the ferromagnetic layer. Further, the ferromagnetic layer is bonded to the dielectric layer or the ferroelectric layer, so that it is possible to obtain a field-effect transistor having a magnetic transition temperature of 0°C or higher. On this account, it is possible to operate the transistor of the present invention at a temperature much higher than that of conventional arts, that is, at 0°C or higher. Specifically, it is possible to control magnetisim, an electricity transport property, and/or a magnetic resistivity effect, at 0°C or higher.

Further, unlike the dilute magnetic semiconductor for example, the Ba-Mn oxide is a "strong correlational electronic system" in which correlation between electrons is extremely strong. Thus, even a slight change in the carrier density changes a property thereof, so that it is possible to control the transistor of the present invention with a lower voltage than that of the dilute magnetic semiconductor.

As described above, it is possible to operate the field-effect transistor of the present invention with a lower voltage at a higher temperature (0°C or higher) than those of conventional arts.

It is more preferable to arrange the field-effect transistor of the present invention so that: the ferromagnetic layer is made of a Ba-Mn oxide whose composition is represented by (La₁₋ₓBaₓ) MnO₃ where x satisfies 0.05<x<0.3.

According to this arrangement, in (La₁₋ₓBaₓ) MnO₃, x is within a range of 0.05<x<0.3, so that the ferromagnetism can be shown at 0°C or higher. Thus, when the Ba-Mn oxide having the foregoing specific composition is used, it is possible to provide the field-effect transistor which can operate at 0°C or higher.

It is more preferable to arrange the field-effect transistor so that: the ferromagnetic layer is made of a Ba-Mn oxide whose composition is represented by (La₁₋ₓBaₓ) MnO₃ where x satisfies 0.10<x<0.3.

That is, in (La₁₋ₓBaₓ) MnO₃, x is within a range of 0.10<x<0.3, so that the ferromagnetism can be shown at 0°C or higher, and it is possible to more widely change the magnetic transition temperature.

It is more preferable to arrange the field-effect transistor of the present invention so that: the dielectric material or the ferroelectric material is BaTiO₃, SrTiO₃, (Ba_{1-y}Sr_{y}) TiO₃, PbTiO₃, Pb (Zr_{1-z}Ti_{z}) TiO₃, or Al₂O₃, where y satisfies 0<y<1 and z satisfies 0<z<1.

Further, it is more preferable to arrange the field-effect transistor of the present invention so that: the dielectric material or the ferroelectric material is BaTiO₃, SrTiO₃, (Ba_{1-y}Sr_{y}) TiO₃, PbTiO₃, or Al₂O₃, where y satisfies 0<y<1.

Any one of the foregoing materials is used as the dielectric material or the ferroelectric material, so that it is possible to provide the field-effect transistor which can efficiently change the magnetic transition temperature.

It is more preferable to arrange the field-effect transistor of the present invention so as to have a bottom-gate structure. The bottom-gate structure is such a structure that the (La, Ba) MnO₃ layer serving as a channel layer (ferromagnetic layer) is not in contact with the substrate and its one side is exposed. More specifically, the (La, Ba) MnO₃ layer is exposed.

According to this arrangement, the field-effect transistor has the bottom-gate structure, so that the (La, Ba) MnO₃ layer is not in contact with the substrate. On this account, the field-effect transistor can be free from any correlation between the substrate and the (La, Ba) MnO₃ layer. Thus, the field-effect transistor can show the ferromagnetism at 0°C or higher, and it is possible to more widely change the magnetic transition temperature.

### [Examples]

### [Example 1]

The following description explains an example where the field-effect transistor according to the present invention is manufactured in accordance with laser ablation.

First, in order to form (La_{0.87}Ba_{0.13}) MnO₃, there were mixed La₂O₃ powder, Mn₂O₃ powder, BaO powder at an appropriate mixture ratio, and thus obtained mixture was preliminarily sintered at 900°C for 40 hours. Thereafter, the preliminarily sintered mixture was subjected to main sinter at 1300°C for 24 hours.

Further, ArF excimer laser (y = 193 nm) is emitted to the (La_{0.87}Ba_{0.13}) MnO₃, so as to form a (La_{0.87}Ba_{0.13}) MnO₃ thin film (with a thickness of 3.6 nm) on a single-crystal SrTiO₃ (001) substrate under such condition that: a substrate temperature was 700°C, and an oxygen gas pressure was 1.0 × 10⁻¹Pa. In this manner, a ferromagnetic layer was formed.

Further, a thin film (with a thickness of 30 nm) made of Pb (Zr, Ti) O₃ was formed on the ferromagnetic layer in accordance with laser ablation. In this manner, a dielectric layer was formed. That is, the substrate, the ferromagnetic layer, and the dielectric layer were stacked in this order. Further, the dielectric layer was not in contact with the substrate.

Next, a gate electrode was formed on the dielectric layer, and a source electrode and a drain electrode were formed on the ferromagnetic layer. Specifically, the source electrode and the drain electrode were formed so as to sandwich the dielectric layer formed on the ferromagnetic layer. In this case, it may be so arranged that the source electrode and the drain electrode are in contact with the dielectric layer or it may be so arranged that they are not in contact with the dielectric layer.

In this manner, the field-effect transistor according to the present embodiment was manufactured. An operating range of the field-effect transistor obtained by the foregoing manufacturing method was 200 µm × 200 µm.

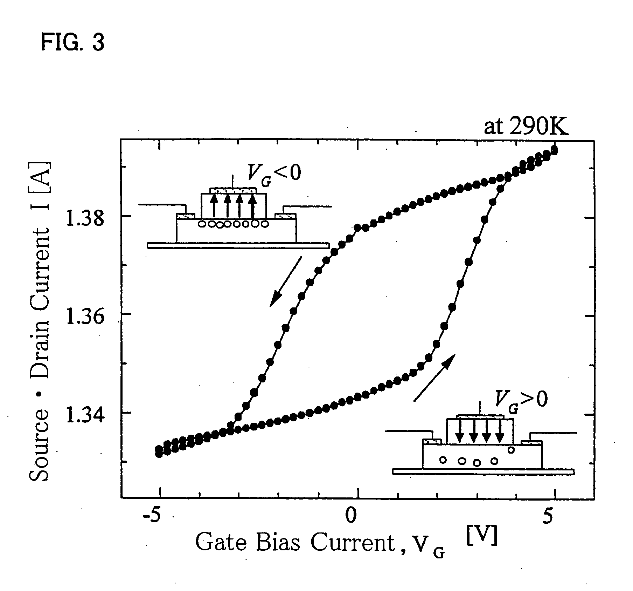

Next, thus obtained field-effect transistor was used to carry out gate-bias sweep at 290 K. This operation caused the source-drain resistivity to be divided by the dielectric layer. Then, it was confirmed whether the carrier density of the ferromagnetic layer effectively changed or not. A result of the confirmation is shown in Fig. 3. As shown in Fig. 3, it was confirmed that the carrier density of the ferromagnetic layer effectively changed.

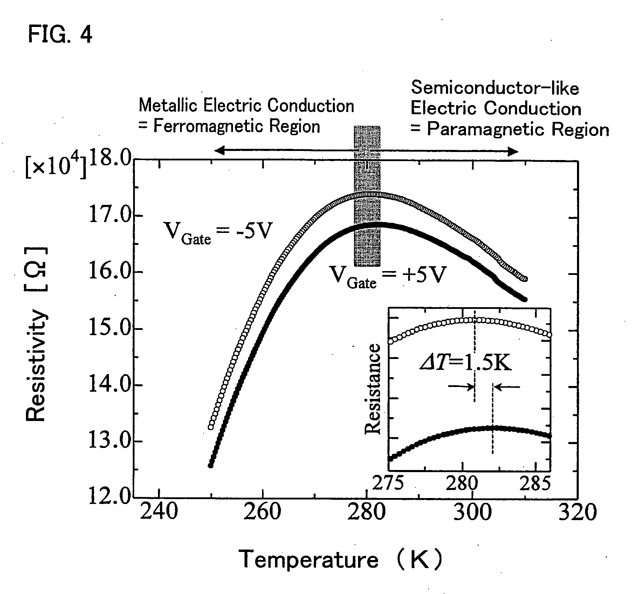

Next, a source-drain resistivity in case where a temperature of the field-effect transistor was changed with an electric field of 5V applied as a gate bias was measured. A result of the measurement is shown in Fig. 4. As apparent from Fig. 4, the ferromagnetic transition temperature (metal-insulator transition temperature) reached 280 K.

Further, as apparent from Fig. 4, the magnetic transition temperature change of 1.5 K was confirmed at 280 K (bulk 270K) under such condition that an electric field of 5V was applied as a gate bias. This means that the ferromagnetic-paramagnetic switching was carried out. Thus, the field-effect transistor of the present invention can operate with a lower voltage at a higher temperature (0°C or higher) than those of conventional arts.

### [Example 2]

The same operation as in Example 1 was carried out except that (La_{0.85}Ba_{0.15}) MnO₃ was used instead of (La_{0.87}Ba_{0.13}) MnO₃, thereby manufacturing the field-effect transistor.

Next, thus obtained field-effect transistor was used to carry out gate-bias sweep at 290K. This operation caused the source-drain resistivity to be divided by the dielectric layer. Then, it was confirmed whether the carrier density of the ferromagnetic layer effectively changed or not. As in Example 1, it was confirmed that the carrier density of the ferromagnetic layer effectively changed.

Further, a source-drain resistivity in case where a temperature of the field-effect transistor was changed with an electric field of 5V applied as a gate bias was measured. As a result of the measurement, the magnetic transition temperature change of 3.0 K was confirmed at 282 K under such condition that an electric field of 5V was applied as a gate bias.

### [Example 3]

The same materials as in Example 2 were used, and laser ablation was adopted, thereby manufacturing a bottom-gate-type field-effect transistor. In this case, a layer thickness (film thickness) of (La_{0.85}Ba_{0.15}) MnO₃ serving as a channel layer was 15 nm. Note that, an oxide gate electrode made of (La, Ba) MnO₃ was formed between the single-crystal SrTiO₃ (001) substrate and Pb (Zr, Ti) O₃ serving as the dielectric layer (gate layer).

Further, a source-drain resistivity in case where a temperature of the field-effect transistor was changed with an electric field of 5V applied as a gate bias was measured. As a result of the measurement, the magnetic transition temperature change of 3.0 K was confirmed at 282 K under such condition that an electric field of 5V was applied as a gate bias.

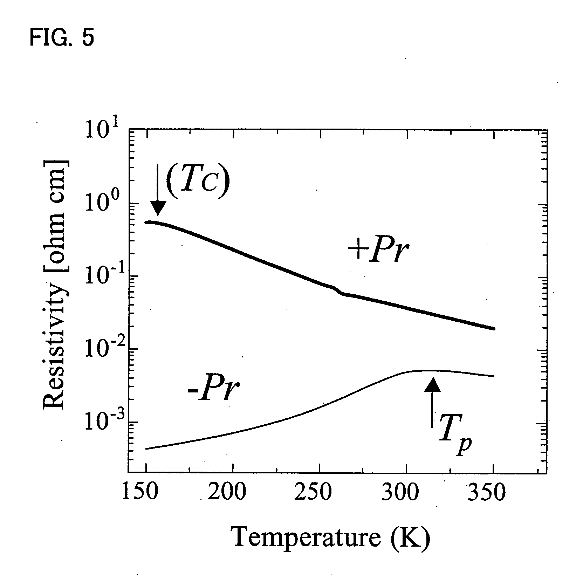

Next, by using thus obtained field-effect transistor, a source-drain resistivity in case where a temperature of the field-effect transistor was changed with an electric field of 5V applied as a gate bias was measured. A result of the measurement is shown in Fig. 5. As apparent from Fig. 5, the ferromagnetic transition temperature (metal-insulator transition temperature) reached 313 K.

Further, as apparent from Fig. 5, the magnetic transition temperature change of 160 K was confirmed at 313 K under such condition that an electric field of 5V was applied as a gate bias. This means that the ferromagnetic-paramagnetic switching was carried out. Thus, the field-effect transistor of the present invention can operate with a lower voltage at a higher temperature (0°C or higher) than those of conventional arts.

The invention being thus described, it will be obvious that the same way may be varied in many ways. Such variations are not to be regarded as a departure from the spirit and scope of the invention, and all such modifications as would be obvious to one skilled in the art are intended to be included within the scope of the following claims.

### INDUSTRIAL APPLICABILITY

The field-effect transistor according to the present invention is applicable to a magnetic storage device in which information can be written with an electric field, a new-feature semiconductor/magnetic integrated circuit, an electric field control magnetic actuator, and the like for example.

## Claims

1. A field-effect transistor, comprising:
a ferromagnetic layer, having a film thickness of 50 nm or less, which is made of a Ba-Mn oxide showing ferromagnetism at 0°C or higher;
a dielectric layer made of a dielectric material or a ferroelectric material, said ferromagnetic layer and said dielectric layer being bonded to each other.

2. The field-effect transistor as set forth in claim 1, wherein the ferromagnetic layer is made of a Ba-Mn oxide whose composition is represented by (La₁₋ₓBaₓ) MnO₃
where x satisfies 0.05<x<0.3.

3. The field-effect transistor as set forth in claim 1, wherein the ferromagnetic layer is made of a Ba-Mn oxide whose composition is represented by (La₁₋ₓBaₓ) MnO₃
where x satisfies 0.10<x<0.3.

4. The field-effect transistor as set forth in claim 1, 2, or 3, wherein the dielectric material or the ferroelectric material is BaTiO₃, SrTiO₃, (Ba_{1-y}Sr_{y}) TiO₃, PbTiO₃, Pb (Zr1-zTiz) TiO₃, or Al₂O₃, where y satisfies 0<y<1 and z satisfies 0<z<1.

5. The field-effect transistor as set forth in claim 1, 2, or 3, wherein the dielectric material or the ferroelectric material is BaTiO₃, SrTiO₃, (Ba_{1-y}Sr_{y}) TiO₃, PbTiO₃, or Al₂O₃, where y satisfies 0<y<1.

6. The field-effect transistor as set forth in any one of claims 1 to 5, having a bottom-gate structure.
